(19) Europäisches Patentamt
European Patent Office
Office européen des brevets

(11) **EP 3 910 504 A1**

(12) **EUROPEAN PATENT APPLICATION**
published in accordance with Art. 153(4) EPC

(43) Date of publication:
**17.11.2021 Bulletin 2021/46**

(51) Int Cl.:
***G06F 17/18*** *(2006.01)*

(21) Application number: **20904298.5**

(22) Date of filing: **13.06.2020**

(86) International application number:
**PCT/CN2020/095990**

(87) International publication number:
**WO 2021/196408 (07.10.2021 Gazette 2021/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.03.2020 CN 202010247950**

(71) Applicant: **Huazhong University of Science and Technology**
**Wuhan**
**Hubei 430074 (CN)**

(72) Inventors:
• **LI, Wenlong**
  **Wuhan**
  **Hubei 430074 (CN)**
• **JIN, Fuquan**
  **Wuhan**
  **Hubei 430074 (CN)**
• **JIANG, Cheng**
  **Wuhan**
  **Hubei 430074 (CN)**
• **FENG, Sheng**
  **Wuhan**
  **Hubei 430074 (CN)**

(74) Representative: **Straus, Alexander**
**2K Patent- und Rechtsanwälte - München**
**Keltenring 9**
**82041 Oberhaching (DE)**

(54) **AVIATION BLADE PROFILE DETECTION METHOD AND SYSTEM BASED ON VARIABLE TOLERANCE ZONE CONSTRAINT**

(57)     The present invention discloses a method and system for determining an aero-engine blade profile based on variable tolerance zone constraints, and belongs to the field of aero-engine blade determination. The method includes: performing a curvature estimation on all points in a blade profile contour measuring point set of an aero-engine blade, performing a downsampling in the blade profile contour measuring point set based on a curvature distribution, randomly performing a circle fitting through sampled blade profile contour measuring points to realize segmentation of the blade profile contour, thus obtaining a leading edge point set, a trailing edge point set, a blade basin point set and a blade back point set; setting tolerance zone ranges and linear constraints for the leading edge point set, the trailing edge point set, the blade basin point set and the blade back point set respectively, building a target matching function, and solving the target matching function to obtain an optimal pose; and performing a rigid body transformation on the aero-engine blade through the optimal pose, comparing the aero-engine blade obtained after rigid body transformation with a designed blade, and evaluating whether a blade profile of the aero-engine blade is qualified or not. The matching result of the aero-engine blade and the designed blade is more exact, so that the accuracy rate of the blade determination is increased.

Performing curvature estimation on all points in a blade profile contour measuring point set of an aviation blade to obtain a curvature distribution, and performing downsampling in the blade profile contour measuring point set based on the curvature distribution to obtain sampled blade profile contour measuring points

Randomly performing circle fitting through the sampled blade profile contour measuring points to realize segmentation of the blade profile contour, thus obtaining a leading edge point set, a trailing edge point set, a blade basin point set and a blade back point set

Performing unconstrained matching by the blade profile contour measuring point set and a nearest point set to obtain an initial pose, setting tolerance zone ranges and linear constraints for the leading edge point set, the trailing edge point set, the blade basin point set and the blade back point set respectively, building a target matching function, and solving the target matching function by taking the initial pose as an initial value to obtain an optimal pose

Performing rigid body transformation on the aviation blade through the optimal pose, comparing the aviation blade obtained after rigid body transformation with the designed blade, and judging whether a blade profile of the aviation blade is qualified or not

FIG. 1

**Description**

**TECHNICAL FIELD**

The present invention relates to the field of aero-engine blade determination, and in particular to a method and system for determiningdetermining an aero-engine blade profile based on variable tolerance constraints.

**BACKGROUND**

As an industrial product with the world recognized most complex structure and highest technical threshold, the aero-engine has always been praised as the pearl of the industrial crown. However, the aero-engine blade, as a core part of the aero-engine, directly affects the aerodynamic performance of the aero-engine, so it is particularly important to accurately control the aviation profile quality. At present, a matching method based on equal tolerance zone constraints is most commonly used in the determination of the aero-engine blade profile, In this respect blade profile contour measuring points are matched with a blade profile contour design model, upon which it is evaluated whether an error value of each point is out of tolerance If yes, the aero-engine blade profile is unqualified, otherwise, the aero-engine blade profile is qualified. Yet, this method does not properly allow to control different precisions of the leading edge and the trailing edge, the blade basin and the blade back of the blade profile. Moreover, since the measuring points of the leading edge and the trailing edge, the blade basin and the blade back of the blade profile are not uniform in density, matching under the equal tolerance constraint often results in a distortion of the matching result, that is, sliding towards the directions of the blade basin and the blade back, thereby leading to incorrect reports of unqualified blade profile caused in that the leading edge and the trailing edge of the blade profile exceed the tolerance.
The prior art has evidently technical problems of distortion of the matching results and false reports of unqualified blade profile.

**SUMMARY**

For the above defects or improvement requirements in the prior art, the present invention provides a method and system for determining an aero-engine blade profile based on variable tolerance zone constraints, thereby solving the technical problems of distortion of the matching result and false reports of unqualified blade profile in the prior art.
To achieve the above objective, according to one aspect of the present invention, a method for determining an aero-engine blade profile based on variable tolerance zone constraints is provided. The method includes the following steps:

(1) performing a curvature estimation on all points in a blade profile contour measuring point set of an aero-engine blade to obtain a curvature distribution, and performing a downsampling in the blade profile contour measuring point set based on the curvature distribution to obtain sampled blade profile contour measuring points;
(2) randomly performing circle fitting through the sampled blade profile contour measuring points to realize segmentation of the blade profile contour, thus obtaining a leading edge point set, a trailing edge point set, a blade basin point set and a blade back point set;
(3) searching the nearest point of each point in the blade profile contour measuring point set in a contour measuring point set of a designed blade to form a nearest point set, performing an unconstrained matching by the blade profile contour measuring point set and the nearest point set to obtain an initial pose, setting tolerance zone ranges and linear constraints for the leading edge point set, the trailing edge point set, the blade basin point set and the blade back point set respectively, building a target matching function, and solving the target matching function by taking the initial pose as an initial value to obtain an optimal pose; and
(4) performing a rigid body transformation on the aero-engine blade through the optimal pose, comparing the aero-engine blade obtained after the rigid body transformation with the designed blade, and determining whether the blade profile of the aero-engine blade is qualified or not.

Further, the curvature estimation may specifically be implemented as follows:
fitting a quadratic curve for a point $p_i$ in the blade profile contour measuring point set of the aero-engine blade by $p_i$ and two points $p_{i-1}$ and $p_{i+1}$ adjacent to $p_i$, and calculating a first-order derivative $y'$ and a second-order derivative $y''$ of

$$\kappa_i = \frac{|y''|}{\sqrt{(1+y'^2)^3}}$$

the quadratic curve at $p_i$ so as to obtain a curvature                    of $p_i$.

Further, the downsampling may specifically be implemented as follows:
calculating a curvature sum of discrete points in the blade profile contour measuring point set so as to make adjacent

$$\sum_{i}^{i+k1} \kappa_i = \sum_{i+k1}^{i+k1+k2} \kappa_i$$

sampling intervals $k1$ and $k2$ meet a relationship , $K_i$ representing a curvature of the $i$-th point in the blade profile contour measuring point set.

Further, step (2) may include:

(21) setting a maximum fitting number $k_{max}$, randomly extracting three points from the sampled blade profile contour measuring points to fit a circle by a least square method, then substituting the remaining points to evaluate whether the remaining points are located in the circle, recording a number $n_i$ of points on the circle, repeating fitting for $k_{max}$ times, and selecting two largest circles, that is, a leading edge and a trailing edge obtained by fitting, to obtain a circle center $(x_l, y_l)$ and a radius $r_l$ of the leading edge and a circle center $(x_t, y_t)$ and a radius $r_t$ of the trailing edge; and (22) searching a leading edge point set in the blade profile contour measuring point set by the circle center and the radius of the leading edge, and searching a trailing edge point set in the blade profile contour measuring point set by the circle center and the radius of the trailing edge so as to obtain a blade basin point set and a blade back point set.

Further, search methods of the leading edge point set and the trailing edge point set are the same; and the search method is as follows: based on the circle center $(x_l, y_l)$ and the radius $r_l$ of the leading edge and a given radius error threshold $\delta r$, searching all points meeting $r_l - \delta r \leq |d| \leq r_l + \delta r$ in the blade profile contour measuring point set to obtain the leading edge point set, wherein $d$ is a distance between the circle center of the leading edge and a point in the blade profile contour measuring point set.

Further, the target matching function may specifically be built as follows: a tolerance zone upper limit $d_{high}^j$ and a tolerance zone lower limit $d_{low}^j$ are set for the leading edge point set, the trailing edge point set, the blade basin point set and the blade back point set respectively, $j = 1, 2, 3, 4$, 1 representing the leading edge point set, 2 representing the trailing edge point set, 3 representing the blade basin point set and 4 representing the blade back point set; four variables $\eta_1$, $\eta_2$, $\eta_3$ and $\eta_4$ with value range of 0-1 are introduced, and a subsection constraint is converted into a linear constraint, that is, $g_1(R,t) = Rp_i + t - q_i - \sum\eta_j d_{high}^j \leq 0$ ,

$g_2(R,t) = Rp_i + t - q_i - \sum\eta_j d_{low}^j \geq 0$ and $i = \eta_j s_j$, $s_j$ being a serial number of four demarcation points for segmenting the blade profile contour, for the points between the serial number being $(s_1, s_2)$, $i=\eta_1 s_1+\eta_2 s_2$, and $\eta_1+\eta_2=1$; and the calculation method of $i$ between other demarcation points is consistent with the above, $R$ being a rotation matrix, $t$ being a translation matrix, $p_i$ being a blade profile contour measuring point, and $q_i$ being the nearest point of $p_i$ in the contour measuring point set of the designed blade, so that a target matching function

$$E(R,t) = min\sum_{i=1}^{n} \| Rp_i + t - q_i \|^2 + \lambda_1 g_1(R,t) + \lambda_2 g_2(R,t)$$

is built, $n$ being a total number of the points in the blade profile contour measuring point set, $\lambda_1$ being a lagrangian multiplier of a first linear constraint $g_1(R,t)$, and $\lambda_2$ being a lagrangian multiplier of a second linear constraint $g_2(R,t)$.

According to another aspect of the present invention, a system for determining an aero-engine blade profile based on variable tolerance zone constraints is provided. The system includes:

a pre-processing module, configured to perform curvature estimation on all points in a blade profile contour measuring point set of an aero-engine blade to obtain a curvature distribution, and configured to perform a downsampling in the blade profile contour measuring point set based on the curvature distribution to obtain sampled blade profile contour measuring points;

a segmentation module, configured to randomly perform circle fitting through the sampled blade profile contour measuring points to realize segmentation of a blade profile contour, thus obtaining a leading edge point set, a trailing edge point set, a blade basin point set and a blade back point set;

a function building module, configured to search a nearest point of each point in the blade profile contour measuring point set in a contour measuring point set of a designed blade to form a nearest point set, perform unconstrained matching by the blade profile contour measuring point set and the nearest point set to obtain an initial pose, set tolerance zone ranges and linear constraints for the leading edge point set, the trailing edge point set, the blade basin point set and the blade back point set respectively, build a target matching function, and solve the target matching function by taking the initial pose as an initial value to obtain an optimal pose; and

a determination module, configured to perform a rigid body transformation on the aero-engine blade through the optimal pose, to compare the aero-engine blade obtained after rigid body transformation with the designed blade, and to evaluate whether a blade profile of the aero-engine blade is qualified or not.

Further, the pre-processing module includes:

a curvature estimation module, configured to fit a quadratic curve for a point $p_i$ in the blade profile contour measuring point set of the aero-engine blade by $p_i$ and two points $p_{i-1}$ and $p_{i+1}$ adjacent to $p_i$, and calculate a first-order derivative $y'$ and

a second-order derivative $y''$ of the quadratic curve at $p_i$ so as to obtain a curvature $\kappa_i = \dfrac{|y''|}{\sqrt{(1+y'^{}{}^{'})^3}}$ of $p_i$; and

a downsampling module, configured to calculate a curvature sum of discrete points in the blade profile contour measuring point set so as to make adjacent sampling intervals $k1$ and $k2$ meet a relationship

$$\sum_{i}^{i+k1} \kappa_i = \sum_{i+k1}^{i+k1+k2} \kappa_i$$

, $K_i$ representing a curvature of the $i$-th point in the blade profile contour measuring point set.

The segmentation module may further include:

a fitting module, configured to set a maximum fitting number $k_{max}$, to randomly extract three points from the sampled blade profile contour measuring points to fit a circle by a least square method, and configured to substitute the remaining points to evaluate whether the remaining points are located in the circle, to record a number $n_j$ of points on the circle, to repeat fitting for $k_{max}$ times, and to select two largest circles, that is, a leading edge and a trailing edge obtained by fitting, to obtain a circle center $(x_l,y_l)$ and a radius $r_l$ of the leading edge and a circle center $(x_t,y_t)$ and a radius $r_t$ of the trailing edge; and

a search module, configured to search a leading edge point set in the blade profile contour measuring point set by the circle center and the radius of the leading edge, and to search a trailing edge point set in the blade profile contour measuring point set by the circle center and the radius of the trailing edge so as to obtain a blade basin point set and a blade back point set.

Further, the target matching function in the function building module may specifically be drafted as follows:

a tolerance zone upper limit $d_{high}^{j}$ and a tolerance zone lower limit $d_{low}^{j}$ are set for the leading edge point set, the trailing edge point set, the blade basin point set and the blade back point set respectively, $j$ = 1, 2, 3, 4, 1 representing the leading edge point set, 2 representing the trailing edge point set, 3 representing the blade basin point set and 4 representing the blade back point set; four variables $\eta_1$, $\eta_2$, $\eta_3$ and $\eta_4$ with a value range of 0-1 are introduced, and a subsection constraint is converted into a linear constraint, that is, $g_1(R,t) = Rp_i + t - q_i - \sum \eta_j d_{high}^{j} \leq 0$

$g_2(R,t) = Rp_i + t - q_i - \sum \eta_j d_{low}^{j} \geq 0$ and $i = \eta_j s_j$, $s_j$ being a serial number of four demarcation points for segmenting the blade profile contour, for the points between the serial number being $(s_1, s_2)$, $i=\eta_1 s_1+\eta_2 s_2$, and $\eta_1+\eta_2$=1; and the calculation method of $i$ between other demarcation points is consistent with the above, $R$ being a rotation matrix, $t$ being a translation matrix, $p_i$ being a blade profile contour measuring point, and $q_i$ being the nearest point of $p_i$ in the contour measuring point set of the designed blade, so that a target matching function

$$E(R,t) = min \sum_{i=1}^{n} \| Rp_i + t - q_i \|^2 + \lambda_1 g_1(R,t) + \lambda_2 g_2(R,t)$$

is built, $n$ being a total number of the points in the blade profile contour measuring point set, $\lambda_1$ being a lagrangian multiplier of a first linear constraint $g_1(R,t)$, and $\lambda_2$ being a lagrangian multiplier of a second linear constraint $g_2(R,t)$.

In general, compared with the prior art, the above technical solutions conceived in the present invention can achieve the following beneficial effects:

(1) according to the present invention, the blade profile contour measuring points are subjected to curvature estimation, the blade profile contour is subjected to curvature sampling, random consistency circle fitting is performed by combining with the leading edge and trailing edge curvature of the blade profile to obtain the leading edge and the trailing edge, the blade profile contour is segmented, the segmentation result is more accurate, the nearest point set of the blade profile contour measuring points is established, the blade profile contour measuring points and the designed contour measuring points are subjected to unconstrained matching to obtain the initial pose, and the target matching function based on the variable tolerance zone constrains is built; and the optimal pose matched with the blade profile with the variable tolerance zone constraints is solved by taking the pose obtained by unconstrained matching as the initial value, the optimal pose solved thereby is more accurate, and the subsequent matching result of the aero-engine blade and the designed blade is truer, such that the accurate rate of the blade determination is improved.

(2) According to the present invention, the tolerance zone ranges and the linear constraints are set for the leading edge point set, the trailing edge point set, the blade basin point set and the blade back point set respectively, the target matching function is built, and the blade profile matching method based on the variable tolerance constrains may perform an accurate control according to different requirements of the leading edge and trailing edge, the blade basin and the blade back of the blade profile; as such the problems such as the distortion problem of slip in the tolerance constraint matching can be effectively improved, and the accurate rate of the blade determination can be increased.

(3) According to the present invention, during sampling, the curvature sum of the discrete points in the blade profile contour measuring point set is calculated, and the adjacent sampling intervals $k1$ and $k2$ meet a certain relationship, thereby realizing multiple sampling in a high-curvature area and less sampling in a low-curvature area.

## BRIEF DESCRIPTION OF THE DRAWINGS

FIG 1 is a flowchart of a method for determining an aero-engine blade profile based on variable tolerance zone constraints according to an embodiment of the present invention;
FIG. 2 is a curvature distribution diagram of an aero-engine blade profile according toy an embodiment of the present invention;
FIG. 3 is a schematic diagram of curvature sampling according to an embodiment of the present invention; and
FIG. 4 is a circle fitting a trailing edge according to an embodiment of the present invention.

## DETAILED DESCRIPTION

To further illustrate the objectives, technical solutions, and advantages of the present invention, the present invention will be further described below in detail with reference to the accompanying drawings and embodiments. It should be understood that the specific embodiments described herein are only used to explain the present invention and are not intended to limit the present invention. In addition, the technical features involved in the various embodiments of the present invention described below may be combined with each other as long as they do not constitute a conflict with each other.

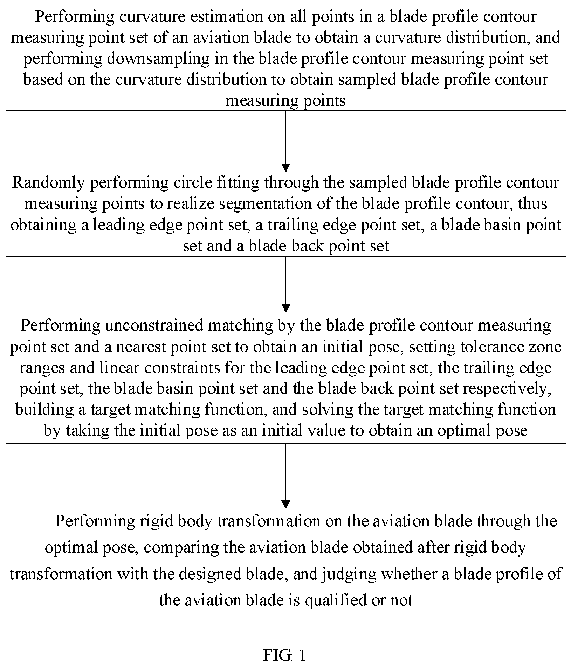

As shown in FIG. 1, a method for determining an aero-engine blade profile based on variable tolerance zone constraints includes the following steps:

(1) a curvature estimation is performed on all points in a blade profile contour measuring point set of an aero-engine blade to obtain a curvature distribution, and a downsampling is performed in the blade profile contour measuring point set based on the curvature distribution to obtain sampled blade profile contour measuring points;

(2) a circle fitting is randomly performed through the sampled blade profile contour measuring points to realize a segmentation of the blade profile contour, thus obtaining a leading edge point set, a trailing edge point set, a blade basin point set and a blade back point set;

(3) a nearest point of each point is searched in the blade profile contour measuring point set in a contour measuring point set of a designed blade to form a nearest point set, an unconstrained matching is performed by the blade profile contour measuring point set and the nearest point set to obtain an initial pose, tolerance zone ranges and linear constraints are set for the leading edge point set, the trailing edge point set, the blade basin point set and the blade back point set respectively, a target matching function is built, and the target matching function is solved by taking the initial pose as an initial value to obtain an optimal pose; and

(4) a rigid body transformation is performed on the aero-engine blade through the optimal pose, the aero-engine blade obtained after rigid body transformation is compared with the designed blade, and it is evaluated whether a blade profile of the aero-engine blade is qualified or not.

In the examples of the present invention, the aero-engine blade profile contour measuring points are collected by devices including, but not limited to a three-coordinate measuring machine, a point laser displacement sensor and an area array scanner. The contour measuring points of the designed blade are given by coordinate information or control parameters of points, line segments, arcs and spline curves.

Further, the curvature estimation is specifically implemented as follows:

a quadratic curve is fit for a point $p_i$ in the blade profile contour measuring point set of the aero-engine blade by $p_i$ and two points $p_{i-1}$ and $p_{i+1}$ adjacent to $p_i$, and a first-order derivative $y'$ and a second-order derivative $y''$ of the quadratic

$$\kappa_i = \frac{|y''|}{\sqrt{(1+y')^3}}$$

curve are calculated at $p_i$ so as to obtain a curvature of $p_i$. Three points $p_{i-1}(x_{i-1}, y_{i-1})$, $p_i(x_i, y_i)$ and $p_{i+1}(x_{i+1}, y_{i+1})$ are used to fit the quadratic curve $y = ax^2 + bx + c$, and parameters $a$, $b$ and $c$ can be solved by solving a matrix equation $AC = y$, wherein

$$A = \begin{bmatrix} 1 & x_{i-1} & x_{i-1}^2 \\ 1 & x_i & x_i^2 \\ 1 & x_{i+1} & x_{i+1}^2 \end{bmatrix}, \quad C = \begin{bmatrix} a \\ b \\ c \end{bmatrix}, \quad y = \begin{bmatrix} y_{i-1} \\ y_i \\ y_{i+1} \end{bmatrix},$$

then the first-order derivative $y' = 2ax_i + b$ and the second-order derivative $y'' = 2a$ of the quadratic curve at $p_i$ are

$$\kappa_i = \frac{|y''|}{\sqrt{(1+y')^3}} = \frac{|2a|}{\sqrt{(1+2ax_i)^3}}$$

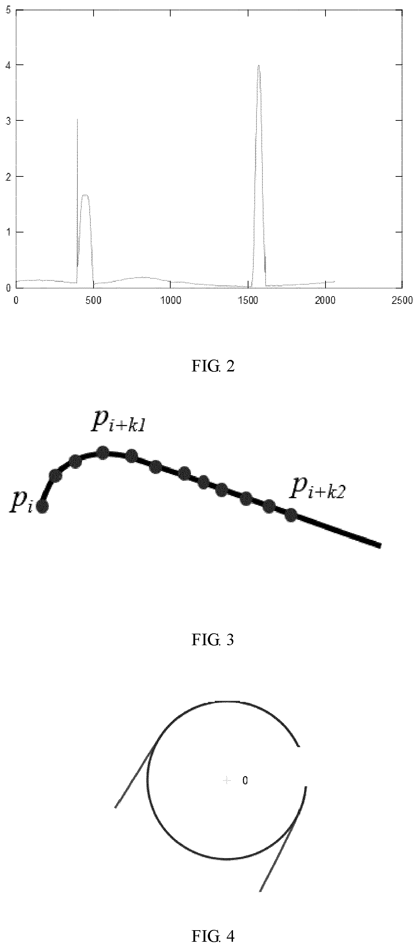

calculated so as to solve the curvature of the point, and the curvature distribution of the blade profile is as shown in FIG. 2.

Further, a downsampling may specifically be implemented as follows:

a curvature sum of discrete points in the blade profile contour measuring point set is calculated, so that adjacent sampling

$$\sum_{i}^{i+k1} \kappa_i = \sum_{i+k1}^{i+k1+k2} \kappa_i$$

intervals $k1$ and $k2$ meet a relationship , wherein $K_i$ represents a curvature of the $i$-th point in the blade profile contour measuring point set. As shown in FIG. 3, the curvature sum between $p_i$ and $p_{i+k1}$ is equal to the curvature sum between $p_{i+k1}$ and $p_{i+k2}$.

Further, step (2) may include:

(21) a maximum fitting number $k_{max} = C_n^3$ is set, wherein $C_n^3$ is a combinatorial number and $n$ is the scale of the contour measuring points after sampling, as shown in FIG. 4, three points are randomly extracted from the sampled blade profile contour measuring points to fit a circle by a least square method, then the remaining points are substituted to evaluate whether the remaining points are located in the circle, the number $n_i$ of the points in the circle is recorded, the fitting is repeated for $k_{max}$ times, and two largest circles, that is, a leading edge and a trailing edge obtained by fitting, are selected to obtain a circle center $(x_l, y_l)$ and a radius $r_l$ of the leading edge and a circle center $(x_t, y_t)$ and a radius $r_t$ of the trailing edge; and

(22) a leading edge point set is searched in the blade profile contour measuring point set by the circle center and the radius of the leading edge, and a trailing edge point set is searched in the blade profile contour measuring point set by the circle center and the radius of the trailing edge so as to obtain a blade basin point set and a blade back point set.

Further, the search methods of the leading edge point set and the trailing edge point set may be the same. The search method may be as follows: based on the circle center $(x_l, y_l)$ and the radius $r_l$ of the leading edge and a given radius error threshold $\delta r$, $\delta r = 0.05 r_l$, all points meeting $r_l - \delta r \le |d| \le r_l + \delta r$ are searched in the blade profile contour measuring point set to obtain the leading edge point set, wherein $d$ is a distance between the circle center of the leading edge and a point in the blade profile contour measuring point set.

The contour curve of the designed blade is uniformly dispersed to obtain a discrete point set $Q$, then kdTree$T_Q$ is established on the point set $Q$, and the nearest point $q_i$ corresponding to the blade profile contour measuring point $p_i$ is searched, so that the nearest point set $Q_{near}$ of the blade profile contour measuring points is obtained. A unconstrained

$$E(R,t) = min \sum_{i=1}^{n} \| d_i \|^2$$

target matching function is established, wherein $d_i = \| Rp_i + t - q_i \|$ is a distance from the blade profile contour measuring point $p_i$ to the nearest point $q_i$, $R$ is a rotation matrix, and $t$ is a translation matrix. $E(R,t) = min\,trace(RC)$ may be obtained by transformation on the target matching function $E(R,t)$, wherein

$$C = \sum_{i=1}^{n} (p_i - \overline{p})(q_i - \overline{q})^T \qquad \overline{p} = \frac{1}{n}\sum_{i=1}^{n} p_i$$

, is the center of the blade profile contour measuring point, and

$$\overline{q} = \frac{1}{n}\sum_{i=1}^{n} q_i$$ is the center of the nearest point set $Q_{near}$. $C$ is subjected to SVD decomposition, and an initial pose may be solved, that is, unstrained matched rotation matrix $R^0$ and translation matrix $t^0$.

The constrained target matching function

$$F(R,t) = min \sum_{i=1}^{n} \| Rp_i + t - q_i \|^2 \; s.t. \; \delta d_{low}^j \le d_i \le \delta d_{high}^j$$ is established, a tolerance zone upper limit $d_{high}^j$ and a tolerance zone lower limit $d_{low}^j$ are set for the leading edge point set, the trailing edge point set, the blade basin point set and the blade back point set respectively, $j = 1, 2, 3, 4$, wherein 1 represents the leading edge point set, 2 represents the trailing edge point set, 3 represents the blade basin point set and 4 represents the blade back point set; four variables $\eta_1$, $\eta_2$, $\eta_3$ and $\eta_4$ with a value range of 0-1 are introduced, and a subsection constraint is converted into a linear constraint, that is, $g_1(R,t) = Rp_i + t - q_i - \sum \eta_j d_{high}^j \le 0$,

$g_2(R,t) = Rp_i + t - q_i - \sum \eta_j d_{low}^j \ge 0$ and $i = \eta_s s_j$, wherein $s_j$ is a serial number of four demarcation points for segmenting the blade profile contour, for the points between the serial number which is $(s_1, s_2)$, $i = \eta_1 s_1 + \eta_2 s_2$, and $\eta_1 + \eta_2 = 1$; and the calculation method of $i$ between other demarcation points is consistent with the above, wherein $R$ is a rotation matrix, $t$ a translation matrix, $p_i$ is a blade profile contour measuring point, and $q_i$ is the nearest point of $p_i$ in the contour measuring point set of the designed blade, a unconstrained target matching function

$$E(R,t) = min \sum_{i=1}^{n} \| Rp_i + t - q_i \|^2 + \lambda_1 g_1(R,t) + \lambda_2 g_2(R,t)$$ is obtained by conversion based on a lagrangian multiplier method, wherein $n$ is the total number of the points in the blade profile contour measuring point set, $\lambda_1$ is a lagrangian multiplier of a first linear constraint $g_1(R,t)$, and $\lambda_2$ is a lagrangian multiplier of a second linear constraint $g_2(R,t)$. The initial pose is taken as an initial value of the unconstrained target matching function, and finally the optimal pose, that is, the optimal rigid body translation matrices $R^*$ and $t^*$, may be obtained through solution.

The method of the present invention is suitable for contour matching of various types of blade profiles of the aero-engine blade.

The skilled in the art will easily understand that the above are only preferred embodiments of the present invention, and that these are not intended to limit the present invention. Any modifications, equivalent substitutions and improvements and the like made within the spirit and principles of the present invention should fall within the protection scope of the present invention.

**Claims**

1. A method for determining an aero-engine blade profile based on variable tolerance zone constraints, **characterized by** comprising the following steps:

   (1) performing a curvature estimation on all points in a blade profile contour measuring point set of an aero-engine blade to obtain a curvature distribution, and performing a downsampling in the blade profile contour measuring point set based on the curvature distribution to obtain sampled blade profile contour measuring points;
   (2) randomly performing a circle fitting through the sampled blade profile contour measuring points to realize a segmentation of the blade profile contour, thus obtaining a leading edge point set, a trailing edge point set, a blade basin point set and a blade back point set;
   (3) searching a nearest point of each point in the blade profile contour measuring point set in a contour measuring point set of a designed blade to form a nearest point set, performing unconstrained matching by the blade profile contour measuring point set and the nearest point set to obtain an initial pose, setting tolerance zone ranges and linear constraints for the leading edge point set, the trailing edge point set, the blade basin point set and the blade back point set respectively, building a target matching function, and solving the target matching function by taking the initial pose as an initial value to obtain an optimal pose; and
   (4) performing a rigid body transformation on the aero-engine blade through the optimal pose, comparing the aero-engine blade obtained after rigid body transformation with the designed blade, and judging whether a blade profile of the aero-engine blade is qualified or not.

2. The method for determining the aero-engine blade profile based on the variable tolerance zone constraints according to claim 1, **characterized in that** the curvature estimation is specifically implemented as follows:
   fitting a quadratic curve for a point $p_i$ in the blade profile contour measuring point set of the aero-engine blade by $p_i$ and two points $p_{i-1}$ and $p_{i+1}$ adjacent to $p_i$, and calculating a first-order derivative $y'$ and a second-order derivative $y''$ of the quadratic curve at $p_i$ so as to obtain a curvature $\kappa_i = \dfrac{|y''|}{\sqrt{(1+y'^2)^3}}$ of $p_i$.

3. The method for determining the aero-engine blade profile based on the variable tolerance zone constraints according to claim 1 or 2, **characterized in that** the downsampling is specifically implemented as follows:
   calculating a curvature sum of discrete points in the blade profile contour measuring point set so as to make adjacent sampling intervals $k1$ and $k2$ meet a relationship $\sum_{i}^{i+k1} \kappa_i = \sum_{i+k1}^{i+k1+k2} \kappa_i$, $K_i$ representing a curvature of the $i$-th point in the blade profile contour measuring point set.

4. The method for determining the aero-engine blade profile based on the variable tolerance zone constraints according to claim 1 or 2, **characterized in that** the step (2) comprises:

   (21) setting a maximum fitting number $k_{max}$, randomly extracting three points from the sampled blade profile contour measuring points to fit a circle by a least square method, then substituting the remaining points to judge whether the remaining points are located in the circle, recording a number $n_i$ of points on the circle, repeating fitting for $k_{max}$ times, and selecting two largest circles, that is, a leading edge and a trailing edge obtained by fitting, to obtain a circle center $(x_l, y_l)$ and a radius $r_l$ of the leading edge and a circle center $(x_t, y_t)$ and a radius $r_t$ of the trailing edge; and
   (22) searching a leading edge point set in the blade profile contour measuring point set by the circle center and the radius of the leading edge, and searching a trailing edge point set in the blade profile contour measuring point set by the circle center and the radius of the trailing edge so as to obtain a blade basin point set and a blade back point set.

5. The method for determining the aero-engine blade profile based on the variable tolerance zone constraints according to claim 4, **characterized in that** search methods of the leading edge point set and the trailing edge point set are the same; and the search method is as follows: based on the circle center $(x_l, y_l)$ and the radius $r_l$ of the leading edge and a given radius error threshold $\delta r$, searching all points meeting $r_l - \delta r \leq |d| \leq r_l + \delta r$ in the blade profile contour measuring point set to obtain the leading edge point set, $d$ being a distance between the circle center of the leading edge and a point in the blade profile contour measuring point set.

6. The method for determining the aero-engine blade profile based on the variable tolerance zone constraints according to claim 1 or 2, **characterized in that** the target matching function is specifically built as follows:

setting a tolerance zone upper limit $d_{high}^{j}$ and a tolerance zone lower limit $d_{low}^{j}$ for the leading edge point set, the trailing edge point set, the blade basin point set and the blade back point set respectively, $j$ =1, 2, 3, 4, 1 representing the leading edge point set, 2 representing the trailing edge point set, 3 representing the blade basin point set and 4 representing the blade back point set; introducing four variables $\eta_1$, $\eta_2$, $\eta_3$ and $\eta_4$ with a value range of 0-1, and converting a subsection constraint into a linear constraint, that is,

$$g_1(R,t) = Rp_i + t - q_i - \sum \eta_j d_{high}^{j} \leq 0$$
,
$$g_2(R,t) = Rp_i + t - q_i - \sum \eta_j d_{low}^{j} \geq 0$$ and $i = \eta_j s_j$, $s_j$ being a serial number of four demarcation points for segmenting the blade profile contour, for the points between the serial number being $(s_1, s_2)$ , $i = \eta_1 s_1 + \eta_2 s_2$, and $\eta_1 + \eta_2 = 1$; and the calculation method of $i$ between other demarcation points being consistent with the above, $R$ being a rotation matrix, $t$ being a translation matrix, $p_i$ being a blade profile contour measuring point, and $q_i$ being a nearest point of $p_i$ in the contour measuring point set of the designed blade, building a target matching function

$$E(R,t) = min \sum_{i=1}^{n} \| Rp_i + t - q_i \|^2 + \lambda_1 g_1(R,t) + \lambda_2 g_2(R,t)$$, $n$ being a total number of the points in the blade profile contour measuring point set, $\lambda_1$ being a lagrangian multiplier of a first linear constraint $g_1(R,t)$, and $\lambda_2$ being a lagrangian multiplier of a second linear constraint $g_2(R,t)$.

7. A system for determining an aero-engine blade profile based on variable tolerance zone constraints, **characterized by** comprising:

a preprocessing module, configured to perform curvature estimation on all points in a blade profile contour measuring point set of an aero-engine blade to obtain a curvature distribution, and configured to perform a downsampling in the blade profile contour measuring point set based on the curvature distribution to obtain sampled blade profile contour measuring points;
a segmentation module, configured to randomly perform circle fitting through the sampled blade profile contour measuring points to realize a segmentation of the blade profile contour, thus obtaining a leading edge point set, a trailing edge point set, a blade basin point set and a blade back point set;
a function building module, configured to search a nearest point of each point in the blade profile contour measuring point set in a contour measuring point set of a designed blade to form a nearest point set, to perform an unconstrained matching by the blade profile contour measuring point set and the nearest point set to obtain an initial pose, set tolerance zone ranges and linear constraints for the leading edge point set, the trailing edge point set, the blade basin point set and the blade back point set respectively, and configured to build a target matching function, and to solve the target matching function by taking the initial pose as an initial value to obtain an optimal pose; and
a determination module, configured to perform a rigid body transformation on the aero-engine blade through the optimal pose, to compare the aero-engine blade obtained after rigid body transformation with the designed blade, and to evaluate whether a blade profile of the aero-engine blade is qualified or not.

8. The system for determining the aero-engine blade profile based on the variable tolerance zone constraints according to claim 7, **characterized in that** the preprocessing module comprises:

a curvature estimation module, configured to fit a quadratic curve for a point $p_i$ in the blade profile contour measuring point set of the aero-engine blade by $p_i$ and two points $p_{i-1}$ and $p_{i+1}$ adjacent to $p_i$, and to calculate a first-order derivative $y'$ and a second-order derivative $y''$ of the quadratic curve at $p_i$ so as to obtain a curvature

$$K_i = \frac{|y''|}{\sqrt{(1+y')^3}}$$ of $p_i$; and

a downsampling module, configured to calculate a curvature sum of discrete points in the blade profile contour measuring point set to make adjacent sampling intervals $k1$ and $k2$ meet a relationship $\sum_i^{i+k1} K_i = \sum_{i+k1}^{i+k1+k2} K_i$, $K_i$ representing a curvature of the $i$-th point in the blade profile contour measuring point set.

9. The system for determining the aero-engine blade profile based on the variable tolerance zone constraints according to claim 7 or 8, **characterized in that** the segmentation module comprises:

a fitting module, configured to set a maximum fitting number $k_{max}$, to randomly extract three points from the sampled blade profile contour measuring points to fit a circle by a least square method, then to substitute the remaining points to evaluate whether the remaining points are located in the circle, to record a number $n_i$ of points on the circle, repeat fitting for $k_{max}$ times, and to select two largest circles, that is, a leading edge and a trailing edge obtained by fitting, to obtain a circle center $(x_l, y_l)$ and a radius $r_l$ of the leading edge and a circle center $(x_t, y_t)$ and a radius $r_t$ of the trailing edge; and

a search module, configured to search a leading edge point set in the blade profile contour measuring point set by the circle center and the radius of the leading edge, and to search a trailing edge point set in the blade profile contour measuring point set by the circle center and the radius of the trailing edge so as to obtain a blade basin point set and a blade back point set.

10. The system for determining the aero-engine blade profile based on the variable tolerance zone constraints according to claim 7 or 8, **characterized in that** the target matching function in the function building module is specifically built as follows:

setting a tolerance zone upper limit $d^j_{high}$ and a tolerance zone lower limit $d^j_{low}$ for the leading edge point set, the trailing edge point set, the blade basin point set and the blade back point set respectively, $j =1, 2, 3, 4, 1$ representing the leading edge point set, 2 representing the trailing edge point set, 3 representing the blade basin point set and 4 representing the blade back point set; introducing four variables $\eta_1$, $\eta_2$, $\eta_3$ and $\eta_4$ with a value range of 0-1, and converting a subsection constraint into a linear constraint, that is,

$$g_1(R, t) = Rp_i + t - q_i - \sum \eta_j d^j_{high} \le 0 \quad , \quad g_2(R, t) = Rp_i + t - q_i - \sum \eta_j d^j_{low} \ge 0$$

and $i = \eta_j s_j$, $s_j$ being a serial number of four demarcation points for segmenting the blade profile contour, for the points between the serial number being $(s_1, s_2)$, $i = \eta_1 s_1 + \eta_2 s_2$, and $\eta_1 + \eta_2 = 1$; and the calculation method of $i$ between other demarcation points being consistent with the above, $R$ being a rotation matrix, $t$ being a translation matrix, $p_i$ being a blade profile contour measuring point, and $q_i$ being the nearest point of $p_i$ in the contour measuring point set of the designed blade, building a target matching function

$$E(R, t) = min \sum_{i=1}^{n} \| Rp_i + t - q_i \|^2 + \lambda_1 g_1(R, t) + \lambda_2 g_2(R, t)$$, $n$ being a total number of the points in the blade profile contour measuring point set, $\lambda_1$ being a lagrangian multiplier of a first linear constraint $g_1(R, t)$, and $\lambda_2$ being a lagrangian multiplier of a second linear constraint $g_2(R, t)$.

Performing curvature estimation on all points in a blade profile contour measuring point set of an aviation blade to obtain a curvature distribution, and performing downsampling in the blade profile contour measuring point set based on the curvature distribution to obtain sampled blade profile contour measuring points

Randomly performing circle fitting through the sampled blade profile contour measuring points to realize segmentation of the blade profile contour, thus obtaining a leading edge point set, a trailing edge point set, a blade basin point set and a blade back point set

Performing unconstrained matching by the blade profile contour measuring point set and a nearest point set to obtain an initial pose, setting tolerance zone ranges and linear constraints for the leading edge point set, the trailing edge point set, the blade basin point set and the blade back point set respectively, building a target matching function, and solving the target matching function by taking the initial pose as an initial value to obtain an optimal pose

Performing rigid body transformation on the aviation blade through the optimal pose, comparing the aviation blade obtained after rigid body transformation with the designed blade, and judging whether a blade profile of the aviation blade is qualified or not

FIG. 1

FIG. 2

$p_{i+k1}$

$p_i$

$p_{i+k2}$

FIG. 3

$0$

FIG. 4

## INTERNATIONAL SEARCH REPORT

| International application No. |
| --- |
| **PCT/CN2020/095990** |

**A. CLASSIFICATION OF SUBJECT MATTER**

G06F 17/18(2006.01)i

According to International Patent Classification (IPC) or to both national classification and IPC

**B. FIELDS SEARCHED**

Minimum documentation searched (classification system followed by classification symbols)

G06F

Documentation searched other than minimum documentation to the extent that such documents are included in the fields searched

Electronic data base consulted during the international search (name of data base and, where practicable, search terms used)

CNABS, CNKI, VEN, CNTXT: 叶面, 叶型, 叶轮, 叶片, 曲率, 拟合, 点, 约束, 轮廓, 公差, blade, lamina, impeller, laminae, vane, curvature, tolerance, fit+, point, contour, profile, limit+, restrict+

**C. DOCUMENTS CONSIDERED TO BE RELEVANT**

| Category* | Citation of document, with indication, where appropriate, of the relevant passages | Relevant to claim No. |
| --- | --- | --- |
| X | CN 106407502 A (XI'AN JIAOTONG UNIVERSITY) 15 February 2017 (2017-02-15) description, paragraphs 0007-0080, figures 1-5 | 1, 7 |
| Y | CN 106407502 A (XI'AN JIAOTONG UNIVERSITY) 15 February 2017 (2017-02-15) description, paragraphs 0007-0080, figures 1-5 | 2-6, 8-10 |
| Y | CN 103486996 A (NORTHWESTERN POLYTECHNICAL UNIVERSITY) 01 January 2014 (2014-01-01) description, paragraphs 0005-0046, figures 1-6 | 2-3, 8 |
| Y | CN 106021782 A (NORTHWESTERN POLYTECHNICAL UNIVERSITY) 12 October 2016 (2016-10-12) description, paragraphs 0005-0040, figure 1 | 4-5, 9 |
| Y | CN 106354927 A (NORTHWESTERN POLYTECHNICAL UNIVERSITY) 25 January 2017 (2017-01-25) description, paragraphs 0004-0168, figures 1-7 | 6, 10 |
| A | CN 110851967 A (SHANXI UNIVERSITY) 28 February 2020 (2020-02-28) entire document | 1-10 |

☑ Further documents are listed in the continuation of Box C.     ☑ See patent family annex.

| | | |
| --- | --- | --- |
| \* | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
| --- | --- |
| **23 December 2020** | **04 January 2021** |

| Name and mailing address of the ISA/CN | Authorized officer |
| --- | --- |
| **China National Intellectual Property Administration (ISA/ CN)** **No. 6, Xitucheng Road, Jimenqiao, Haidian District, Beijing 100088** **China** | |
| Facsimile No. **(86-10)62019451** | Telephone No. |

Form PCT/ISA/210 (second sheet) (January 2015)

**INTERNATIONAL SEARCH REPORT**

| International application No. |
| --- |
| **PCT/CN2020/095990** |

**C.    DOCUMENTS CONSIDERED TO BE RELEVANT**

| Category* | Citation of document, with indication, where appropriate, of the relevant passages | Relevant to claim No. |
| --- | --- | --- |
| A | CN 103411574 A (NORTHWESTERN POLYTECHNICAL UNIVERSITY) 27 November 2013 (2013-11-27)<br>    entire document | 1-10 |
| A | CN 103761389 A (BEIHANG UNIVERSITY et al.) 30 April 2014 (2014-04-30)<br>    entire document | 1-10 |
| A | CN 103148784 A (HARBIN YINGRUIDA SCIENCE AND TECHNOLOGY DEVELOPMENT CO., LTD.) 12 June 2013 (2013-06-12)<br>    entire document | 1-10 |
| A | US 2014076038 A1 (MTU AERO ENGINES AG) 20 March 2014 (2014-03-20)<br>    entire document | 1-10 |

Form PCT/ISA/210 (second sheet) (January 2015)

## INTERNATIONAL SEARCH REPORT
### Information on patent family members

International application No.

**PCT/CN2020/095990**

| Patent document cited in search report | | | Publication date (day/month/year) | Patent family member(s) | | | Publication date (day/month/year) |
|---|---|---|---|---|---|---|---|
| CN | 106407502 | A | 15 February 2017 | CN | 106407502 | B | 14 January 2020 |
| CN | 103486996 | A | 01 January 2014 | CN | 103486996 | B | 20 January 2016 |
| CN | 106021782 | A | 12 October 2016 | | None | | |
| CN | 106354927 | A | 25 January 2017 | CN | 106354927 | B | 10 May 2019 |
| CN | 110851967 | A | 28 February 2020 | | None | | |
| CN | 103411574 | A | 27 November 2013 | CN | 103411574 | B | 20 January 2016 |
| CN | 103761389 | A | 30 April 2014 | CN | 103761389 | B | 17 August 2016 |
| CN | 103148784 | A | 12 June 2013 | CN | 103148784 | B | 20 January 2016 |
| US | 2014076038 | A1 | 20 March 2014 | EP | 2707576 | A2 | 19 March 2014 |
| | | | | WO | 2012152255 | A3 | 14 February 2013 |
| | | | | WO | 2012152255 | A2 | 15 November 2012 |
| | | | | DE | 102011101097 | A1 | 15 November 2012 |
| | | | | US | 9068826 | B2 | 30 June 2015 |
| | | | | EP | 2707576 | B1 | 04 March 2015 |

Form PCT/ISA/210 (patent family annex) (January 2015)